Europäisches Patentamt

European Patent Office

Office européen des brevets

(19)

(11) Veröffentlichungsnummer : **0 093 706
B1**

(12) **EUROPÄISCHE PATENTSCHRIFT**

(45) Veröffentlichungstag der Patentschrift :
06.05.87

(21) Anmeldenummer : 83890070.2

(22) Anmeldetag : 03.05.83

(51) Int. Cl.⁴ : **C 23 C 28/00, C 23 C 16/32,
C 23 C 16/34, C 23 C 16/36,
C 23 C 14/26, B 32 B 15/04**

(54) **Werkzeug und Verfahren zu dessen Herstellung.**

(30) Priorität : 05.05.82 AT 1758/82

(43) Veröffentlichungstag der Anmeldung :
09.11.83 Patentblatt 83/45

(45) Bekanntmachung des Hinweises auf die Patenterteilung : 06.05.87 Patentblatt 87/19

(84) Benannte Vertragsstaaten :
DE FR GB IT SE

(56) Entgegenhaltungen :
AT-B-   326 971
DE-A- 2 851 584
DE-A- 3 006 308
PATENTS ABSTRACTS OF JAPAN, unexamined applications, C Section, Vol. 3, No. 83, 18, Juli 1979 THE PATENT OFFICE JAPANESE GOVERNMENT page 6 C 52

(73) Patentinhaber : **VEREINIGTE EDELSTAHLWERKE AKTIENGESELLSCHAFT (VEW)
Elisabethstrasse 12
A-1010 Wien (AT)**

(72) Erfinder : **Krainer, Ekkehart, Dr.
Mariazellerstrasse 20
A-8605 Kapfenberg (AT)**
Erfinder : **Pacher, Oskar, Dr.
Peter Tunner-Gasse 17
A-8605 Kapfenberg (AT)**
Erfinder : **Zeman, Friedrich, Dipl.-Ing.
Peter Tunner-Gasse 16
A-8605 Kapfenberg (AT)**
Erfinder : **Kiefer, Johann
Sölsnitz 3
A-8641 St. Marein (AT)**

(74) Vertreter : **Widtmann, Georg, Dr.
Vereinigte Edelstahlwerke Aktiengesellschaft (VEW)
Elisabethstrasse 12
A-1010 Wien (AT)**

EP 0 093 706 B1

**Beschreibung**

Die Erfindung betrifft ein Werkzeug, dessen Grundkörper aus Stahl besteht und mit einem mehrschichtigen, vorzugsweise verschleißfesten, Überzug versehen ist. Solche Werkzeuge finden insbesondere in der spanabhebenden Metallbearbeitung Verwendung, es seien nur beispielsweise Dreh-, Schneid- und Fräs-Werkzeuge, Fräsköpfe, Bohrer, Sägen u. dgl. genannt. Die erfindungsgemäßen Werkzeuge können aber auch für andere Zwecke als die spanabhebende Verformung Anwendung finden, z. B. als Preßstempel, Gesenke od. dgl.

Es sind mehrere Verfahren bekannt, metallische Werkstoffe mit Hartstoffen zu überziehen, um eine erhöhte Verschleißfestigkeit zu erreichen. Diese Verfahren können z. B. bei Ziehdüsen, Lagerauskleidungen, Stempeln und ähnlichen Teilen eine Verlängerung der Nutzungsdauer bringen.

Es ist ferner seit langem bekannt, Hartmetalle mit einer oder mehreren Hartstoffschichten zu überziehen und als Werkzeuge für die zerspanende Bearbeitung von Werkstoffen, insbesondere Metallen, einzusetzen. Die für diese Anwendung geeigneten Hartmetalle sind vornehmlich pulvermetallurgisch hergestellte Legierungen, die bei Temperaturen von etwa 1 400 bis 1 500 °C gesingert werden und z. B. aus einer mit 4 bis 12 Gew.-% Kobalt gebundenen Hartstoffmatrix aus Wolframcarbid mit unterschiedlichen Gehalten an Titan- und/oder Tantalcarbid bestehen. Diese Hartmetalle haben die vorzügliche Eigenschaft, bis zu sehr hohen Temperaturen ohne Gefügeänderung in ihrer Form stabil zu bleiben.

Die Hartstoff-Schutzschichten werden üblicherweise durch Abscheidung aus der Gasphase nach dem CVD-Verfahren (Chemical Vapor Deposition) aufgetragen, bei welchem die zu beschichtenden Grundkörper in einem Ofen zunächst auf 900 bis 1 200 °C aufgeheizt und anschließend mit einem Gasgemisch — beispielsweise bestehend aus $H_2$, einem Metallhalogenid, z. B. $TiCl_4$, $N_2$ und/oder $CH_4$ — behandelt werden.

Nach einer Behandlungsdauer von einigen Stungen sind die so behandelten Oberflächen mit einer Deckschicht aus Metall-Nitriden, -Carbonitriden oder -Carbiden, z. B. TiN oder TiC, überzogen.

Der Nachteil beschichteter Hartmetalle liegt aber in deren Sprödigkeit, wodurch ihre Anwendung für Schneidoperationen mit scharfen Schneiden und kleinen Keilwinkeln bei niederen und mittleren Schnittgeschwindigkeiten unmöglich wird. Auch die in der Literatur vielfach zitierten Schutzschichten und Schichtkombinationen und CVD-Beschichtungsverfahren im Normal- und Unterdruckbereich haben in dieser Hinsicht keinen Fortschritt gebracht.

Wendet man diese Verfahren für die Beschichtung von Werkzeugen aus Stahl an, so ergeben sich durch die CVD-Beschichtung fallweise äußerst weitführende Schädigungen des Grundwerkstoffes.

Zu diesen Schädigungen zählt, daß der Stahlgrundkörper nach der Beschichtung in einem weichgeglühten, oftmals sehr grobkörnigen Gefügezustand vorliegt und nach der Beschichtung noch gehärtet und angelassen werden muß. Durch die nachträglichen Temperaturbehandlungen erfolgt jedoch eine beträchtliche Volumensänderung, welche die durchwegs spröden Hartstoffschichten unter starke Spannung setzt. Dadurch kommt es zum Verzug und zur Ausbildung von Mikrorissen in der Schicht und letztlich zu Schichtablösungen.

Zusätzlich kann es zum Auftreten von mehr oder minder starken Entkohlungen in der Randzone zur Schicht kommen, wodurch ein irreversibler Härteverlust derartige Schneidwerkzeuge unbrauchbar werden läßt.

Bei qualitativ hochwertigen Präzisionswerkzeugen aus Schnellarbeitsstahl wie Wälzfräsern, Zahnformfräsern und ähnlichen Werkzeugen, wie sie für die Herstellung von Verzahnungen Verwendung finden, aber auch bei weniger anspruchsvollen, scharfkantigen Schneidwerkzeugen mit engen Toleranzen ist als besonders schwerwiegender Nachteil der durch die Beschichtung und nachfolgende Härtung hervorgerufene Verzug hervorzuheben.

CVD-beschichtete Wälzstoßwerkzeuge, Formfräser oder Spiralbohrer können wegen dieser Verzugserscheinungen und Maßänderungen überhaupt nicht eingesetzt werden.

Es hat deshalb nicht an Versuchen gefehlt, mit Hilfe anderer Verfahren die vorgenannten Nachteile zu beseitigen.

So hat z. B. die Abscheidung und Bildung von Hartstoffphasen aus einem Schmelzbad mit B-, C-, N-hältigen Metallsalzen für formstabile Schneidwerkzeuge keinen Fortschritt gebracht.

Auch aufgespritzte Schichten, wie sie teilweise beim Verschleißschutz für z. B. Kolbenringe, Führungsbüchsen, Gesenke, Rührarme od. dgl. Verwendung finden, haben sich bei Zerspanungswerkzeugen nicht bewährt. Die Ursache dafür waren in einer zu geringen Schichthaftung und einer zu hohen Oberflächenrauhigkeit kombiniert mit sehr stark wechselnden Schichtdicken zu suchen, wodurch es zu einem ungleichmäßigen Verschleißbild und zu Frühausfällen des gesamten Werkzeuges gekommen ist.

Auch das Glimmnitrieren der Oberflächen hat für Schneidwerkzeuge nur geringe und unbedeutende Anwendung gefunden.

Wesentlich aussichtsreicher waren die sogenannten PVD-Beschichtungsverfahren, welche unter dem Begriff Physical Vapor Deposition alle Verfahren umfassen, welche für die Abscheidung von Hartstoffen bei relativ niedrigen Temperaturen verwendet werden können. Die DE-OS 28 42 393 beschreibt z. B. ein PVD-Verfahren für die Herstellung goldgelber Überzüge auf der Basis TiN oder ZrN für die Uhrenindustrie. Das Ziel dieses Verfahrens war die Herstellung reproduzierbarer, goldähnlicher Farbtöne für Schmuckzwekke.

Durch systematische Entwicklungen auf dem PVD-Gebiet wurde es auch möglich, Schneidwerkzeuge verzugsfrei mit TiN zu beschichten.

Viele dieser Arbeiten gehen auf R. F. Bunshah und Mitarbeiter zurück, die ein aktiviertes PVD-Verfahren für die Abscheidung von TiC auf Schnellarbeitsstahl vorschlagen (US-PS 3 791 852, 1974).

Als Hauptproblem hat sich aber die Haftung der Schichten herausgestellt, die bei Abscheidetemperaturen unterhalb der Anlaßtemperatur auf Stahlteilen nicht ausreichend war. Um diese Nachteile zu vermeiden, wurde z. B. in der DE-OS 30 27 526 vorgeschlagen, sauerstoffhältige Oxicarbonitride unter Verwendung geeigneter Atmosphären mit bekannten PVD-Verfahren aufzutragen. Es hat sich aber gezeigt, daß auch derartige Schichten eine mangelhafte Schichthaftung aufweisen können. Die Ursachen dafür dürften darin liegen, daß selbst nach einer gründlichen Oberflächenreinigung durch Ionenbeschuß relativ hohe Sauerstoffgehalte in der Oberfläche der zu beschichtenden Teile vorliegen.

Dieser Restsauerstoffgehalt dürfte für verschiedene Haftungsprobleme verantwortlich sein. Messungen des Restsauerstoffgehaltes in der Oberfläche sind z. B. von Akira Kono in « Advanced Metal Finishing Technology » in Japan 1980 dargestellt.

Es scheint somit naheliegend, durch Abscheidung sauerstoffhältiger Nitrid- bzw. Carbidschutzschichten eine bessere Affinität zur Sauerstoffhältigen Metalloberfläche zu erreichen, um auf diese Weise die Haftung zu verbessern. Allerdings liegen die praktisch anwendbaren Sauerstoffwerte bei sehr niedrigen Gehalten, da die Verschleißeigenschaften, wie Härte und Abriebfestigkeit, durch höhere Sauerstoffgehalte sehr rasch reduziert werden.

Überraschenderweise hat sich gezeigt, daß eine wesentliche Verbesserung der Schichthaftung dadurch zu erzielen ist, daß ein mehrlagiger Schichtaufbau mit einer hinsichtlich der Harstoffbildner Stickstoff und/oder Kohlenstoff unterstöchiometrischen bzw. einer rein metallischen Haftschicht direkt auf das Stahlsubstrat aufgebracht wird.

Gegenstand der Erfindung ist somit ein Werkzeug für, insbesondere spanabhebende, Werkstoffbearbeitung, dessen Grundkörper aus Stahl besteht und mit einem mehrschichtigen Hartstoff-Überzug versehen ist, das dadurch gekennzeichnet ist, daß auf dem Stahl-Grundkörper eine Basis-Beschichtung aus mindestens einem Metall aus der Gruppe Ti, Zr, Hf, V, Ta und Nb oder bzw. und darüber eine zumindest einlagige Basis-Beschichtung bzw. Zwischen-Beschichtung aus einem hinsichtlich der nichtmetallischen hartstoffbildenden Elemente unterstöchiometrischen Nitrid und/oder Carbid mindestens eines der Metalle aus der Gruppe Ti, Zr, Hf, V, Ta und Nb aufgetragen ist bzw. sind, worüber eine zumindest einlagige Deck-Beschichtung aus einem stöchiometrischen Nitrid, Carbonitrid und/oder Carbid mindestens eines der Metalle aus der Gruppe Ti, Zr, Hf, V, Ta und Nb angeordnet ist.

Besonders bevorzugt ist die unterstöchiometrische Basis-bzw. Zwischenbeschichtung aus Nitrid und/oder Carbid der obengenannten sechs Metalle mit der allgemeinen Formel $Me\,X_{(1-x)}$ worin Me mindestens eines der genannten sechs Metalle und X Kohlenstoff und/oder Stickstoff bedeuten und $1 > x > 0$ gebildet.

Weiters ist es bevorzugt, wenn dementsprechend die Deckbeschichtung aus Nitrid und/oder Carbid der genannten sechs Metalle mit der allgemeinen Formel Me Y (worin Me eines der sechs genannten Metalle und Y Stickstoff und/oder Kohlenstoff bedeuten) gebildet ist.

Gegebenenfalls sogar eine Erhöhung der Haftung kann erreicht werden, wenn das unterstöchiometrische Carbid und/oder Nitrid etwa 0,2 bis etwa 0,3 Atome Sauerstoff pro Metallatom aufweist.

Es kann also die auf den Stahl-Grundkörper aufgebrachte Beschichtung eine Basis-Beschichtung aus mindestens einem der genannten reinen Metalle sein oder eine solche aus einem nichtstöchiometrischen Nitrid und/oder Carbid mindestens eines der genannten Metalle.

Weiters kann auf den Stahl-Grundkörper eine rein metallische Basis-Beschichtung aufgetragen sein, über welcher die unterstöchiometrische Nitrid- und/oder Carbid-Beschichtung, die für diesen Fall als « Zwischen-Beschichtung » bezeichnet ist, angeordnet ist.

Eine rein metallische bzw. metallreiche Basis-Beschichtung hat gegenüber einer stöchiometrischen Hartstoffschicht, z. B. aus TiN, den Vorteil, Verunreinigungen in der Stahloberfläche, wie Sauerstoff- und Kohlenstoffspuren, bei den üblicherweise angewendeten Abscheidungstemperaturen von 400 bis 600 °C aufzunehmen und an das Metall bzw. das in stöchiometrischem Überschuß vorhandene Metall in der sich direkt auf dem Stahl-Grundkörper befindlichen Beschichtung zu binden. Diese Vorgänge dürften die Verbesserung der Haftung der aufgebrachten Hartstoffschicht auf der Stahlmatrix erklären.

An dieser Stelle sei erwähnt, daß der Grundkörper der erfindungsgemäßen Werkzeuge aus auf üblichem Wege hergestellten Stählen bestehen kann, aber ohne weiters auch aus auf pulvermetallurgischem Wege hergestellten Stählen.

Um die schon vorher erörterten Nachteile des CVD-Verfahrens zu umgehen, ist mindestens eine der Beschichtungen, vorzugsweise sind jedoch alle Beschichtungen, auf physikalischem Wege abgeschieden. Bei dieser Art der Abscheidung, insbesondere nach dem PVD-Verfahren, bei dem die abzuscheidenden Elemente in der Gasphase vorliegend beispielsweise einer Plasmaentladung unterworfen werden, kann der Einsatz von das Substrat verändernden Stoffen, wie z. B. von Metallchloriden, die zur Entkohlung führen, vermieden werden.

Durch geeignete Wahl der Abscheideparameter innerhalb der hinsichtlich der nichtmetallischen

3

Hartstoffbildner unterstöchiometrischen Schicht kann deren Härte und Zähigkeit vorteilhaft an jene des Stahl-Substrates angepaßt werden.

So sind z. B. besonders für Fräser unterstöchiometrische (Zwischen)-Beschichtungen mit einer Mikrohärte zwischen 1 000 und 2 000 HV günstig, wobei Schichtaufbau und -dicke der unterstöchiometrischen Schicht dem jeweiligen Zerspannungs- oder Verschleißproblem anpaßbar sind.

Ein gradueller bzw. kontinuierlicher Härteübergang oder auch ein viellagiger Übergang mit extrem dünnen einheitlichen Einzel-Lagen hat sich auch hinsichtlich der Ausbildung von Restspannungen in der hochverschleißfesten Hartstoff-Deckschicht mit einer Mikrohärte von 2 300 HV (50 g Belastung) als günstig erwiesen.

Durch einen abgestuften oder quasi-kontinuierlichen Härteübergang in den aufeinanderfolgenden Lagen der (Zwischen)-Beschichtung und entsprechende Anpassung im Elastizitäts-Modul wird erreicht, daß der Unterschied im Ausdehnungsverhalten zwischen Hartstoff-Deckschicht und der Stahlmatrix bei Temperaturänderung optimal abgebaut werden kann. Dieser Effekt ist insbesondere bei Fräswerkzeugen, bei deren Betrieb ständig Temperaturwechsel-Belastungen auftreten, besonders wichtig.

Demgemäß ist bei einer bevorzugten Ausführungsform der Erfindung vorgesehen, daß die sich direkt auf dem Stahl-Grundkörper bzw. auf der Basis-Beschichtung befindliche Beschichtung bzw. Zwischen-Beschichtung und/oder die Deck-Beschichtung aus mehreren lagen verschiedener, gegebenenfalls sich hinsichtlich der nichtmetallischen Hartstoffbildner kontinuierlich ändernder, Zusammensetzung aufgebaut ist bzw. sind.

Die bei den erfindungsgemäßen Werkzeugen erreichte Verbesserung des Haftvermögens der verschleißfesten Überzüge auf dem Stahl-Substrat bewirkt eine unmittelbare Verlängerung der Standzeit der Werkzeuge auf Basis von Stahl-Grundkörpern.

Es ist aber ein weiterer Vorteil des erfindungsgemäß vorgesehenen Schichtaufbaues, daß die Nachschleifbarkeit, insbesondere bei spanabhebenden Werkzeugen, gegenüber mit bisher üblichen Beschichtungen versehenen Werkzeugen verbessert wird.

Es ist bekannt, daß HSS-Werkzeuge nach Erreichung eines gewissen Verschleißes nachgeschliffen werden müssen. Dieses Nachschleifen wird so durchgeführt, daß die im Einsatz befindlichen Schneiden jeweils an einer Seite nachgeschliffen bzw. nachgesetzt werden.

Bei beschichteten Werkzeugen erzielt man damit Schneiden, die möglichst genau an der Schneidkante einen Übergang vom Grundmaterial zur Beschichtung aufweisen. Im Vergleich zu unbeschichteten Werkzeugen können derartige Schneidwerkzeuge immer noch eine bis zu 200 %ige Standzeiterhöhung bringen.

Voraussetzung dafür ist aber, daß durch das Nachschleifen an der Schneidkante keine Ausbrüche in den Überzügen auftreten. Derartige Ausbrüche sind immer dann festzustellen, Wenn die Sprödigkeit der Überzüge zu groß ist, die Haftung am Grundkörper nicht optimal ist oder innerhalb des Überzuges Spannungen herrschen.

Die vorliegende Erfindung bringt somit auch den Vorteil, neben einer Verbesserung der Schichthaftung und der Zerspanungsleistung auch die Nachschleifbarkeit der Werkzeuge zu verbessern.

Erfindungsgemäß bevorzugt sind Werkzeuge bzw. Verschleißteile, bei denen die gegebenenfalls vorhandene Basis-Beschichtung, die unterstöchiometrische (Zwischen)-Beschichtung und die Deck-Beschichtung auf Basis desselben Metalles bzw. desselben Gemisches von Metallen aus der Gruppe Ti, Zr, Hf, V, Ta und Nb aufgebaut sind. Bevorzugt sind sie auf Basis von Ti und/oder Hf gebildet.

Dementsprechend kann vice versa vorgesehen sein, daß sowohl die « unterstöchiomtrische » Beschichtung bzw. Zwischen-Beschichtung als auch Deck-Beschichtung jeweils auf Basis von Nitrid oder Carbonitrid, vorzugsweise von Nitrid, aufgebaut sind. Vorzugsweise stimmen die Basis-Beschichtung hinsichtlich des sie bildenden Metalls, die Basisbeschichtung bzw. Zwischen-Beschichtung und die Deck-Beschichtung sowohl hinsichtlich des Metalls als auch des nichtmetallischen Hartstoffbildners miteinander überein.

Besonders bevorzugt ist eine Ausführungsform, bei der die gegebenenfalls vorhandene Basis-Beschichtung aus metallischem Titan oder Hafnium, und/oder die Basis-Beschichtung bzw. Zwischen-Beschichtung aus, gegebenenfalls mehreren, vorzugsweise ansteigende, Stickstoff-Gehalte aufweisenden Lagen aus hinsichtlich N unterstöchiometrischem Titannitrid bzw. Hafniumnitrid, insbesondere aus $TiN_{(1-x)}$ bzw. $HfN_{(1-x)}$, $(1 > x > 0)$ und die Deck-Beschichtung aus stöchiometrischem Titannitrid bzw. Hafniumnitrid gebildet sind.

Ein günstiges Betriebsverhalten läßt sich mit Werkzeugen erreichen, bei denen die gegebenenfalls vorhandene Basis-Beschichtung eine Dicke bis zu etwa 1 μm, die zumindest einlagige « unterstöchiometrische » Beschichtung bzw. Zwischen-Beschichtung eine solche von insgesamt etwa 1 bis etwa 3 μm, insbesondere von etwa 2 μm, und die Deck-Beschichtung eine solche von etwa 1 bis etwa 8 μm, insbesondere von etwa 3 μm, aufweisen.

Die Herstellung der erfindungsgemäßen Werkzeuge erfolgt vorteilhaft in der Weise, daß auf einem Stahl-Grundkörper auf physikalischem Wege, vorzugsweise nach der Methode der Physical Vapor Deposition (PVD-Methode), beispielsweise mittels Plasma-Entladung, aus den entsprechenden Metalldampf enthaltender Gasphase eine Basis-Beschichtung mindestens eines der Metalle aus der Gruppe, bestehend aus Ti, Zr, Hf, V, Ta und Nb, oder bzw. und danach aus einer den Dampf mindestens eines der genannten sechs Metalle und ein mindestens einen nichtmetallischen Hartstoffbildner aus der Gruppe

4

Stickstoff und Kohlenstoff lieferndes Gas enthaltenden Gasphase, eine zumindest einlagige, aus einem hinsichtlich des nichtmetallischen Hartstoffbildners unterstöchiometrischen Nitrid und/oder Carbid mindestens eines der sechs oben genannten Metalle, vorzugsweise aus einem Hartstoff der allgemeinen Formel $Me\,X_{(1-x)}$ (worin Me mindestens eines der sechs genannten Metalle, X Stickstoff und/oder Kohlenstoff bedeuten und $1 > x > 0$) gebildete Basis-Beschichtung bzw. Zwischen-Beschichtung, und schließlich aus einer den Dampf mindestens eines der genannten sechs Metalle und ein mindestens einen der Hartstoffbildner Stick- und/oder Kohlenstoff lieferndes Gas enthaltenden Gasphase eine Deck-Beschichtung aus einem stöchiometrischen Nitrid und/oder Carbid mindestens eines der sechs oben genannten Metalle abgeschieden werden.

Gegebenenfalls kann vorgesehen werden, daß die wie beschrieben, abgeschiedene (Zwischen)-Beschichtung aus unterstöchiometrischen Carbid und/oder Nitrid mit etwa 0,2 bis etwa 0,3 Atomen Sauerstoff pro Metallatom aufgebaut wird.

Zur Erreichung besonders haltbarer, gegebenenfalls auftretende Spannungen zwischen Stahl-Grundkörper und Deck-Beschichtung ausgleichende Verschleiß-Überzüge aufweisender Werkzeuge kann vorgesehen werden, daß zur Bildung einer aus mehreren unterschiedliche, vorzugsweise nach außen ansteigende Gehalte an nichtmetallischen Hartstoffbildnern aufweisenden, Lagen bestehenden, unterhalb der Deck-Beschichtung angeordneten Basis-Beschichtung bzw. Zwischen-Beschichtung im Laufe der Abscheidung dieser Beschichtung der Gehalt des Gasphase an die nichtmetallischen Hartstoffbildner Stickstoff und/oder Kohlenstoff und gegebenenfalls Sauerstoff liefernden Gasen geändert, vorzugsweise gesteigert, wird. Die genannte Steigung der genannten Gehalte in der Gasphase kann, wenn ein stufenloser Eigenschaftsübergang gewünscht ist, kontinuierlich erfolgen.

Diese Erfindung sei anhand der folgenden Beispiele näher erläutert :

## Beispiel 1

Ein Wälzfräser für die Herstellung eines evolventen Schrägstirnrades aus einem Schnellarbeitsstahl S 6-5-2-5 wird nach einer Ultraschallvorreinigung in eine Beschichtungsanlage eingebaut und bei einem Argon-Druck von $6 \cdot 10^{-2}$ mbar, 15 min ionengeätzt. Dabei erwärmt sich der Wälzfräser auf 450 °C.

Für die Herstellung des mehrlagigen Überzuges wird anschließend an die Ionen-Ätzung Titanmetall aus einem Tiegel verdampft und eine reaktive Gasatmosphäre so eingestellt, daß ein Gemisch aus $N_2$, Ar und $O_2$ bis zu einem Gesamtdruck von $2 \cdot 10^{-3}$ mbar in eine Plasmaentladung eingeleitet wird.

Das Mischungsverhältnis wird dabei so eingestellt, daß der $N_2$-Partialdruck während einer Beschichtungsdauer von 3 min $6 \cdot 10^{-4}$ mbar beträgt und während einer Beschichtungszeit von 6 min kontinuierlich oder in mehreren Stufen auf $1 \cdot 10^{-3}$ mbar angehoben wird.

Danach wird in einer reinen $N_2$-Atmosphäre bei einem Druck von $2 \cdot 10^{-3}$ mbar während einer Dauer von 10 min eine TiN-Schicht aufgetragen. Nach dem Abkühlen weist der Wälzfräser eine direkt auf das Grundmaterial aufgetragene, hinsichtlich des N-Gehaltes stark unterstöchiometrische, etwa 0,5 µm dicke, und 0,2 Atome Sauerstoff pro Titanatom aufweisende Haftschicht auf, die über eine Zwischenschicht von 2 µm Dicke — nahezu kontinuierlich — in eine 2,5 µm dicke TiN-Schicht übergeht.

Durch die unterstöchiometrische Haftschicht und den graduellen Härteübergang konnte eine um 30 % bessere Standzeit gegenüber einlagig TiN-beschichteten Wälzfräsern erzielt werden.

Nach dem Nachschleifen lag der Standzeitvorteil, aufgrund der verminderten Ausbruchempfindlichkeit, immer noch um 50 % höher als beim vergleichbaren Wälzfräser mit einer einfachen TiN-Beschichtung, der durch das Nachschleifen deutliche Schichtabsplitterungen zeigte.

## Beispiel 2

Nach ISO-Norm wurden Wendeschneidplatten SPUN 120 308 aus Schnellarbeitsstahl S 10-4-3-10 hergestellt. Nach einer Reinigung wurden die Platten in eine Beschichtungsanlage eingesetzt und bei einem Ar-Druck von $1 \cdot 10^{-2}$ mbar ionengeätzt.

Zum Zweck der Schichtaufbringung wurde zuerst Ti-Metall verdampft und mittels einer reaktiven Gasatmosphäre eine unterstöchiometrische Haftschicht der Zusammensetzung $TiN_{0,7}$ abgeschieden. Der Gesamtdruck lag während dieser Abscheidung bei $8 \cdot 10^{-4}$ mbar. Nach 5 min war eine etwa 0,7 µm dicke unterstöchiometrische Schicht aufgebracht. Danach wurde in einer $N_2$-Atmosphäre mit 10 % Ar und einem Arbeitsdruck von $2 \cdot 10^{-3}$ mbar während einer Zeit von 10 min eine 1,5 µm dicke TiN-Schicht aufgebracht. Um eine höhere Verschleißfestigkeit an der Freifläche zu erhalten, wurde eine 1 µm dicke TiC-Schicht aufgebracht. Diese bildete sich in einer Kohlenwasserstoffatmosphäre aus Äthylen und Argon bei einem Druck von $3 \cdot 10^{-3}$ mbar und einem Mischungsverhältnis von 3 : 1.

Um an der Spanfläche die guten diffusionshemmenden Eigenschaften einer TiN-Schicht zu nutzen, wurde nach den bereits beschriebenen Parametern eine 0,75 µm dicke TiN-Schicht aufgetragen.

Mit den erfindungsgemäß hergestellten Platten wurden Zerspanungsversuche am Werkstoff 34 CrNiMo 6 (Vergütungsstahl) bei v = 50 m/min, a = 2.0 mm und s = 0,224 mm/U durchgeführt.

Bei einem unbeschichteten Vergleichswerkzeug lag die mittlere Verschleißmarkenbreite nach 11,2 min bei 0,18 mm und nach 15,5 min erfolgte aufgrund eines zu starken Verschleißes das Standzeitende. Die erfindungsgemäße Platte zeigte nach 11,2 min eine Verschleißmarkenbreite von nur 0,06 mm und nach 16 min erst einen Freiflächenverschleiß von 0,08 mm.

## Beispiel 3

Ein gehärtetes Sägeblatt aus einem Schnellarbeitsstahl wird nach einer Vorreinigung in einem organischen Entfettungsbad in die Beschichtungsanlage eingebaut und bei einem Ar-Druck von $4 \cdot 10^{-2}$ mbar durch Ionenbeschuß während einer Dauer von 12 min gereinigt.

Bei diesem Vorgang befindet sich das Sägeblatt auf einem negativen Potential und erwärmt sich durch den Ionenbeschuß mit positiven Ar-Ionen auf etwa 360 °C. Danach wird das Sägeblatt auf 500 °C erwärmt und während einer Zeit von 30 s bei einem Ar-Druck von $6 \cdot 10^{-4}$ mbar reines Ti-Metall verdampft. Unmittelbar daran anschließend wird ein $N_2$-Partialdruck von $3 \cdot 10^{-4}$ mbar eingestellt. Nach 40 s wird der $N_2$-Partialdruck auf $1 \cdot 10^{-3}$ mbar gesteigert und nach weiteren 4 min wird der Ar-Partialdruck auf $5 \cdot 10^{-4}$ mbar und der $N_2$-Partialdruck auf $2 \cdot 10^{-3}$ mbar eingestellt.

Während einer Dauer von 10 min wird mit diesen Einstellungen eine etwa 2 μm dicke TiN-Deckschicht aufgetragen.

Beim Trennen von Wellen aus einem Stahl der Werkstoff- Nr. 1.6582 konnte mit dem beschichteten Sägeblatt eine 400 %ige Standzeitverbesserung erzielt werden.

## Beispiel 4

Schaftfräser aus S 6-5-2-5, die für die Bearbeitungen von Flugzeugbauteilen aus X 5 NiCrCuNb 17 4 4 verwendet werden, wurden nach Vorreinigung mit organischen Lösungsmitteln, in die Beschichtungskammer eingebaut und bei einem Druck von $5 \cdot 10^{-2}$ mbar 15 min lang durch Ionenbeschuß geätzt. Anschließend wurde für die Dauer von 60 s bei $5 \cdot 10^{-3}$ mbar Druck mit reinem V-Metall beschichtet.

Auf dieser Basisschichte wurde eine 1 μm dicke Zwischenschicht aus VC abgeschieden. Die Reaktionsatmosphäre bestand dabei aus einem Gemisch von Kohlenwasserstoff, z. B. Äthylen und Argon. Die abgeschiedene VC-Schicht wies unterstöchiometrischen C-Gehalt auf.

Darauf wurde eine 2 μm dicke TiN-Schicht als Decklage aufgebracht, was eine wesentliche Verringerung der Neigung zu Verschweißungen von austenitischen Werkstoffen mit den Werkzeugen erbrachte. Mit derart beschichteten Werkzeugen wurden gegenüber herkömmlichen TiN-Beschichtungen Mehrleistungen von 40-50 % erreicht.

Darüber hinaus konnten aufgrund des günstigen Reibungsverhaltens die Schnittkräfte reduziert und damit die Verformung dünner Stege durch zu hohe Schnittkräfte bei der Bearbeitung vermieden werden.

## Beispiel 5

Ein Fließpreßstempel, hergestellt aus X 41 CrMoV 5 1, zur Fertigung von Hülsen aus einem Stahlwerkstoff wurde nach entsprechender Vorreinigung in der Beschichtungsanlage ionengeätzt, wobei die Werkstücktemperatur deutlich unterhalb der Anlaßtemperatur des Werkzeuges lag.

Zur Aufbringung der Basisschicht wurde zuerst bei einem Druck von $5 \cdot 10^{-4}$ mbar Zr verdampft und anschließend auf die 0,5 μm dicke Grundschicht unter Steigerung des $N_2$-Partialdruckes eine 1,5 μm dicke Zwischenschicht aus hinsichtlich N unterstöchiometrischem ZrN abgeschieden.

Anschließend wurde in einer $N_2$-Ar-Atmosphäre mit einem Gasdruck von $2 \cdot 10^{-3}$ mbar eine 2 μm dicke stöchiometrische TiN-Deckschicht aufgebracht.

Die nach diesem Verfahren behandelten Werkzeuge erbrachten eine Erhöhung der Standmenge um 400 % gegenüber herkömmlichen, unbeschichteten Werkzeugen.

## Beispiel 6

Spiral-Bohrer nach DIN 1414, 8 mm Ø, aus Schnellarbeitsstahl wurden in organischen Lösungsmitteln mit Ultraschall gereinigt und auf Vorrichtungen befestigt, welche in eine Beschichtungsanlage eingebaut wurden.

Die Bohrer wurden analog zu Beispiel 5 durch Ionenbeschuß gereinigt.

Als erste Schicht wird reines Hf in einer Dicke von etwa 0,5 μm aufgebracht. Dazu wurde Hf-Metall aus einem Tiegel mittels Elektronenstrahlkanone verdampft und Ar bei einem Druck von $6 \cdot 10^{-4}$ mbar eingeleitet, daß eine Plasmaentladung eintritt.

Auf diese Schicht wird eine etwa 2 μm dicke « unterstöchiometrische » Hf(C, N)-Schicht bei einem Arbeitsdruck von $3 \cdot 10^{-3}$ mbar in einer Atmosphäre, die aus 10 % Ar, 30 % Äthylen und 60 % $N_2$ bestand, abgeschieden. Um die Verschleißfestigkeit noch weiter zu erhöhen, wurde noch eine 1,5 μm dicke, stöchiometrische HfC-Schicht abgeschieden. Dies geschah, indem Stickstoff durch Äthylen ersetzt wurde.

Derart beschichtete Bohrer wurden in Gegenüberstellung zu unbeschichteten und nur mit TiN (nach dem Ion-Plating-Verfahren) beschichteten Bohrern getestet.

Bei einer Schnittgeschwindigkeit von 25 m/min und einem Vorschub von 0,1 mm/U wurden am Werkstoff 41 CrMo 4 bei einem Verschleiß von 0,175 mm folgende Bohrtiefen erreicht :

| | |
|---|---|
| unbeschichtete Bohrer | 2 000 mm |
| nur mit TiN beschichtete Bohrer | 5 000 mm |
| gemäß diesem Beispiel beschichtete Bohrer | 6 000 mm |

Dies zeigt, daß durch die erfindungsgemäße Beschichtung eine Standzeitverlängerung um das 3fache erreicht wird.

Beispiel 7

Ein Schmiedegesenk aus einem Stahl X 30 WCrV 5 3 zur Herstellung von Kurbelwellen für Kettensägenmotoren wurde sorgfältig gereinigt und in eine Beschichtungsanlage eingebaut.

Nach dem Evakuieren wurde das Gesenk bei einem Druck von $5 \cdot 10^{-2}$ mbar mit Ar 20 min ionengeätzt, wobei sich der Teil erwärmte.

Anschließend wird eine mehrlagige Schicht aufgebracht. Dazu wird Hf-Metall aus einem Tiegel verdampft und eine Gasatmosphäre derart eingestellt, daß aus einem $N_2$-Ar-Gemisch bei einem Gesamtdruck von $1 \cdot 10^{-3}$ mbar eine Plasmaentladung stattfindet.

Anschließend wird in einer reinen $N_2$-Atmosphäre während 15 min bei einem Druck von $1 \cdot 10^{-3}$ mbar HfN aufgebracht. Eine metallographische Untersuchung zeigte eine 1,5 μm dicke, hinsichtlich N unterstöchiometrische HfN-Schicht, an die eine reine HfN-Deck-Schicht von 3 μm Dicke anschließt.

Wurden bisher beim Schmieden Standzeiten von 2 000 Stück erzielt, so wurde durch die erfindungsgemäße Beschichtung die Standzeit auf 3 100 Stück erhöht.

**Patentansprüche**

1. Werkzeug für, insbesondere spanabhebende Werkstoffbearbeitung, dessen Grundkörper aus Stahl besteht und mit einem mehrschichtigen Hartstoff-Überzug versehen ist, dadurch gekennzeichnet, daß auf dem Stahl-Grundkörper eine Basis-Beschichtung aus mindestens einem Metall aus der Gruppe Ti, Zr, Hf, V, Ta und Nb oder bzw. und darüber eine zumindest einlagige Basis-Beschichtung bzw. Zwischen-Beschichtung aus einem hinsichtlich der nichtmetallischen hartstoffbildenden Elemente unterstöchiometrischen Nitrid und/oder Carbid mindestens eines der Metalle aus der Gruppe Ti, Zr, Hf, V, Ta und Nb aufgetragen ist bzw. sind, worüber eine zumindest einlagige Deck-Beschichtung aus einem stöchiometrischen Nitrid, Carbonitrid und/oder Carbid mindestens eines der Metalle aus der Gruppe Ti, Zr, Hf, V, Ta und Nb angeordnet ist.

2. Werkzeug nach Anspruch 1, dadurch gekennzeichnet, daß die Basis- bzw. Zwischenbeschichtung aus einem Nitrid und/oder Carbid der allgemeinen Formel Me $X_{(1-x)}$ gebildet ist, worin Me mindestens eines der im Anspruch 1 genannten sechs Metalle und X Kohlenstoff und/oder Stickstoff bedeuten und $1 > x > 0$.

3. Werkzeug nach Anspruch 1 oder 2, dadurch gekennzeichnet, daß die Deckbeschichtung aus einem stöchiometrischen Nitrid, Carbonitrid und/oder Carbid der allgemeinen Formel Me Y gebildet ist, worin Me mindestens eines der im Anspruch 1 genannten sechs Metalle und Y Stickstoff und/oder Kohlenstoff bedeuten.

4. Werkzeug nach einem der Ansprüche 1 bis 3, dadurch gekennzeichnet, daß die zumindest einlagige Basis-Beschichtung bzw. Zwischen-Beschichtung aus einem hinsichtlich der nichtmetallischen hartstoffbildenden Elemente unterstöchiometrischen, etwa 0,2 bis etwa 0,3 Atome Sauerstoff pro Metallatom enthaltenden Nitrid und/oder Carbid mindestens eines der im Anspruch 1 genannten Metalle gebildet ist.

5. Werkzeug nach einem der Ansprüche 1 bis 4, dadurch gekennzeichnet, daß mindestens eine der Beschichtungen auf physikalischem Wege abgeschieden ist.

6. Werkzeug nach einem der Ansprüche 1 bis 5, dadurch gekennzeichnet, daß die sich direkt auf dem Stahl-Grundkörper bzw. auf der Basis-Beschichtung befindliche Beschichtung bzw. Zwischen-Beschichtung und/oder die Deck-Beschichtung aus mehreren Lagen verschiedener Zusammensetzung aufgebaut ist bzw. sind.

7. Werkeug nach Anspruch 6, dadurch gekennzeichnet, daß sich die in diesem Anspruch genannte(n) Beschichtung(en) aus mehreren Lagen sich hinsichtlich der nichtmetallischen Hartstoffbildner kontinuierlich ändernder Zusammensetzung aufgebaut ist bzw. sind.

8. Werkzeug nach einem der Ansprüche 1 bis 7, dadurch gekennzeichnet, daß die gegebenenfalls vorhandene metallische Basis-Beschichtung, die unterstöchiometrische Basis-Beschichtung bzw. Zwischen-Beschichtung und die Deck-Beschichtung auf Basis desselben Metalles bzw. desselben Gemisches von Metallen aus der Gruppe Ti, Zr, Hf, V, Ta und Nb aufgebaut sind.

9. Werkzeug nach einem der Ansprüche 1 bis 8, dadurch gekennzeichnet, daß sowohl die Deck-Beschichtung als auch die darunterliegende unterstöchiometrische Basis-Beschichtung bzw. Zwischen-Beschichtung jeweils auf Basis von Nitrid oder Carbonitrid aufgebaut sind.

7

10. Werkzeug nach einem der Ansprüche 1 bis 9, dadurch gekennzeichnet, daß die gegebenenfalls vorhandene Basis-Beschichtung aus metallischem Titan oder Hafnium bzw. unterstöchiometrische Basis-Beschichtung bzw. Zwischen-Beschichtung aus einer Lage oder mehreren, ansteigende Stickstoff-Gehalte aufweisenden Lagen aus hinsichtlich N unterstöchiometrischem Titannitrid bzw. Hafniumnitrid und die Deck-Beschichtung aus stöchiometrischem Titannitrid bzw. Hafnium-nitrid gebildet sind.

11. Werkzeug nach einem der Ansprüche 1 bis 10, dadurch gekennzeichnet, daß die gegebenenfalls vorhandene Basis-Beschichtung eine Dicke bis zu etwa 1 $\mu$m, die zumindest einlagige, unterstöchiometrische Basis-Beschichtung bzw. Zwischen-Beschichtung eine solche von insgesamt etwa 1 bis etwa 3 $\mu$m und die Deck-Beschichtung eine solche von etwa 1 bis etwa 8 $\mu$m aufweisen.

12. Verfahren zur Herstellung des Werkzeuges nach einem der Ansprüche 1 bis 11, dadurch gekennzeichnet, daß auf einem Stahl-Grundkörper auf physikalischem Wege aus den entsprechenden Metalldampf enthaltender Gasphase eine Basis-Beschichtung mindestens eines der Metalle aus der Gruppe bestehend aus Ti, Zr, Hf, V, Ta und Nb oder bzw. und danach aus einer den Dampf mindestens eines der genannten sechs Metalle und ein mindestens einen nichtmetallischen Hartstoffbildner aus der Gruppe Stickstoff und Kohlenstoff lieferndes Gas enthaltenden Gasphase, eine zumindest einlagige, aus einem hinsichtlich des nichtmetallischen Hartstoffbildners unterstöchiometrischen Nitrid und/oder Carbid mindestens eines der sechs oben genannten Metalle gebildete Basis-Beschichtung bzw. Zwischen-Beschichtung, und schließlich aus einer den Dampf mindestens eines der genannten sechs Metalle und ein mindestens einen der nichtmetallischen Hartstoffbildner Stick- und/oder Kohlenstoff lieferndes Gas enthaltenden Gasphase eine Deck-Beschichtung aus einem stöchiometrischen Nitrid und/oder Carbid mindestens eines der sechs oben genannten Metalle abgeschieden werden.

13. Verfahren nach Anspruch 12, dadurch gekennzeichnet, daß aus einer Sauerstoff lieferndes Gas enthaltenden Gasphase eine 0,2 bis 0,3 Atome Sauerstoff pro Metallatom enthaltendes unterstöchiometrisches Nitrid und/oder Carbid aufweisende Basis- bzw. Zwischen-Beschichtung abgeschieden wird.

14. Verfahren nach Anspruch 12 oder 13, dadurch gekennzeichnet, daß zur Bildung einer aus mehreren unterschiedliche Gehalte an nichtmetallischen Hartstoffbildnern aufweisende Lagen bestehenden, unter der Deck-Beschichtung angeordneten unterstöchiometrischen Beschichtung bzw. Zwischen-Beschichtung, im Laufe der Abscheidung dieser Beschichtung, bzw. Zwischen-Beschichtung, der Gehalt der Gasphase an die nichtmetallischen Hartstoffbildner Stickstoff und/oder Kohlenstoff und gegebenenfalls Sauerstoff lieferndem Gas geändert wird.

**Claims**

1. A tool, in particular for machining of material by chip removal, the main body of which consists of steel and is provided with a multi-layer coating of hardened material, characterized in that the main body of steel has applied to it a base coating of at least one metal from the group Ti, Zr, Hf, V, Ta and Nb or — or additionally thereover — an at least one-layer base coating or intermediate coating of a nitride and/or carbide — which is hypo-stoichiometric with respect to the non-metallic elements forming hardened material — of at least one of the metals of the group Ti, Zr, Hf, V, Ta and Nb, over which is provided an at least one-layer covering coating of a stoichiometric nitride, carbonitride and/or carbide of at least one of the metals of the group Ti, Zr, Hf, V, Ta and Nb.

2. A tool according to claim 1, characterized in that the base coating or intermediate coating is formed by a nitride and/or carbide of the general formula Me $X_{(1-x)}$, in which Me represents at least one of the six metals named in Claim 1 and X represents carbon and/or nitrogen and $1 > x > 0$.

3. A tool according to claim 1 or 2, characterized in that the covering coating is formed by a stoichiometric nitride, carbonitride and/or carbide of the general formula Me Y, in which Me represents at least one of the six metals named in Claim 1 and Y represents nitrogen and/or carbon.

4. A tool according to any one of claims 1 to 3, characterized in that the at least one-layer base coating or intermediate coating is formed by a nitride and/or carbide — which is hypo-stoichiometric with respect to the non-metallic elements forming hardened material and contains about 0.2 to about 0.3 atoms of oxygen per metal atom — of at least one of the metals named in Claim 1.

5. A tool according to any one of claims 1 to 4, characterized in that at least one of the coatings is deposited by physical means.

6. A tool according to any one of claims 1 to 5, characterized in that the coating or intermediate coating and/or the covering coating provided directly on the main body of steel or on the base coating is or are formed by a plurality of layers of different composition.

7. A tool according to claim 6, characterized in that the coating or coatings disclosed in the said Claim is or are formed by a plurality of layers of a composition which continuously changes with respect to the non-metallic hardened material formers.

8. A tool according to any one of claims 1 to 7, characterized in that the metallic base coating, where present. the hypo-stoichiometric base coating or intermediate coating and the covering coating are formed on the basis of the same metal or the same mixture of metals from the group Ti, Zr, Hf, V, Ta and Nb.

9. A tool according to any one of claims 1 to 8, characterized in that both the covering coating and

**0 093 706**

the hypo-stoichiometric base coating or the intermediate coating lying thereunder are formed in each case on the basis of nitride or carbonitride.

10. A tool according to any one of claims 1 to 9, characterized in that the base coating, where present, is formed by metallic titanium or hafnium, the hypo-stoichiometric base coating or intermediate coating are formed by a layer or a plurality of layers — which have increasing nitrogen contents — of titanium nitride or hafnium nitride which are stoichiometric with respect to nitrogen, and the covering coating is formed by stoichiometric titanium nitride or hafnium nitride.

11. A tool according to any one of claims 1 to 10, characterized in that the base coating, where present, has a thickness of up to approximately 1 μm, the at least single-layer hypo-stoichiometric base coating or intermediate coating has a thickness of altogether about 1 to about 3 μm, and the covering coating has a thickness of about 1 to about 8 μm.

12. A method of producing a tool according to any one of claims 1 to 11, characterized in that, on a main body of steel and by physical means, a base coating of at least, one of the metals of the group comprising Ti, Zr, Hf, V, Ta and Nb is deposited from a gas phase containing the corresponding metal vapour or — or additionally thereafter — an at least single-layer base coating or intermediate coating formed by a nitride and/or carbide — which is hypo-stoichiometric with respect to the non-metallic hardened material former — of at least one of the aforesaid six metals is deposited from a gas phase containing the vapour of at least one of the aforesaid six metals and a gas supplying at least one non-metallic hardened material from the group of nitrogen and carbon, and finally a covering coating of a stoichiometric nitride and/or carbide of at least one of the aforesaid six metals is deposited from a gas phase containing the vapour of at least one of the aforesaid six metals and a gas supplying at least one of the non-metallic hardened material formers with nitrogen and/or carbon.

13. A method according to claim 12, characterized in that a base coating or intermediate coating comprising hypo-stoichiometric nitride and/or carbide containing 0.2 to 0.3 atoms of oxygen per atom of metal is deposited from a gas phase containing gas supplying oxygen.

14. A method according to claim 12 or 13, characterized in that, in order to form a hypo-stoichiometric coating or intermediate coating which is situated below the covering coating and which consists of a plurality of layers comprising different contents of non-metallic hardened material formers, in the course of depositing this coating or intermediate coating a change is made to the content of the gas phase of gas supplying the non-metallic hardened material formers nitrogen and/or carbon and where appropriate oxygen.

## Revendications

1. Outil pour l'usinage de matériaux, en particulier avec enlèvement de copeaux, dont le corps principal est formé d'acier et muni d'un revêtement de matière dure à plusieurs couches, caractérisé en ce que sur le corps principal en acier est ou sont appliqués un revêtement de base formé d'au moins un métal du groupe Ti, Zr, Hf, V, Ta et Nb et/ou par-dessus, un revêtement de base ou revêtement intermédiaire à au moins une couche, formé d'un nitrure et/ou carbure d'au moins un des métaux du groupe Ti, Zr, Hf, V, Ta et Nb, hypostœchiométrique en ce qui concerne les éléments non métalliques formateurs de matière dure, par-dessus quoi est disposé un revêtement de recouvrement à au moins une couche formé d'un nitrure, carbonitrure et/ou carbure stœchiométrique d'au moins un des métaux du groupe Ti, Zr, Hf, V, Ta et Nb.

2. Outil selon la revendication 1, caractérisé en ce que le revêtement de base ou intermédiaire est formé d'un nitrure et/ou carbure de la formule générale Me $X_{(1-x)}$ dans laquelle Me désigne au moins un des six métaux précités et X le carbone et/ou l'azote avec $1 > x > 0$.

3. Outil selon la revendication 1 ou 2, caractérisé en ce que le revêtement de recouvrement est formé d'un nitrure, carbonitrure et/ou carbone stœchiométrique de la formule générale Me Y dans laquelle Me désigne au moins un des six métaux cités à la revendication 1 et Y l'azote et/ou le carbone.

4. Outil selon l'une des revendications 1 à 3, caractérisé en ce que le revêtement de base ou intermédiaire à au moins une couche est formé d'un nitrure et/ou carbure d'au moins un des métaux précités, hypostœchiométrique en ce qui concerne les éléments non métalliques formateurs de matière dure, contenant environ 0,2 à environ 0,3 atome d'oxygène par atome de métal.

5. Outil selon l'une des revendications 1 à 4, caractérisé en ce qu'au moins un des revêtements a été déposé par voie physique.

6. Outil selon l'une des revendications 1 à 5, caractérisé en ce que le revêtement ou revêtement intermédiaire placés directement sur le corps principal en acier ou sur le revêtement de base, et/ou le revêtement de recouvrement, sont formés de plusieurs couches de composition différente.

7. Outil selon la revendication 6, caractérisé en ce que le ou les revêtements mentionnés à ladite revendication sont formés de plusieurs couches de composition variant de façon continue en ce qui concerne les formateurs non métalliques de matière dure.

8. Outil selon l'une des revendications 1 à 7, caractérisé en ce que le revêtement métallique de base éventuellement présent, le revêtement de base ou revêtement intermédiaire hypostœchiométrique et le revêtement de recouvrement sont constitués sur la base du même métal ou du même mélange de métaux

9

du groupe Ti, Zr, Hf, V, Ta et Nb.

9. Outil selon l'une des revendications 1 à 8, caractérisé en ce qu'aussi bien le revêtement de recouvrement que le revêtement de base ou revêtement intermédiaire hypostœchiométrique placé en dessous sont constitués chacun à base de nitrure ou carbonitrure.

10. Outil selon l'une des revendications 1 à 9, caractérisé en ce que le revêtement de base de titane ou hafnium métallique éventuellement prévu, ou le revêtement de base ou revêtement intermédiaire hypostœchiométrique, est formé d'une ou plusieurs couches de nitrure de titane ou nitrure de hafnium, hypostœchiométrique en ce qui concerne N, présentant des teneurs en azote croissantes, et le revêtement de recouvrement, de nitrure de titane ou nitrure de hafnium stœchiométrique.

11. Outil selon l'une des revendications 1 à 10, caractérisé en ce que le revêtement de base éventuellement présent présente une épaisseur allant jusqu'à environ 1 μm, le revêtement de base ou revêtement intermédiaire hypostœchiométrique à au moins une couche, une épaisseur d'environ 1 à environ 3 μm en tout et le revêtement de recouvrement une épaisseur d'environ 1 à environ 8 μm.

12. Procédé pour la fabrication de l'outil selon l'une des revendications 1 à 11, caractérisé en ce que sur un corps principal en acier, on dépose par voie physique, en partant de la phase gazeuse contenant la vapeur métallique correspondante, un revêtement de base d'au moins un des métaux du groupe formé de Ti, Zr, Hf, V, Ta et Nb et/ou ensuite, en partant d'une phase gazeuse contenant la vapeur d'au moins un des six métaux cités et un gaz fournissant au moins un formateur non métallique de matière dure, du groupe comprenant l'azote et le carbone, on dépose un revêtement de base ou revêtement intermédiaire à au moins une couche, formé d'un nitrure et/ou carbure d'au moins un des six métaux précités, hypostœchiométrique en ce qui concerne le formateur non métallique de matière dure, et enfin, en partant d'une phase gazeuse contenant la vapeur d'au moins un des six métaux précités et un gaz fournissant au moins un des formateurs non métalliques de matière dure, un revêtement de recouvrement formé d'un nitrure et/ou carbure stœchiométrique d'au moins un des six métaux précités.

13. Outil selon la revendication 12, caractérisé en ce qu'en partant d'une phase gazeuse contenant un gaz fournissant de l'oxygène, on dépose un revêtement de base ou intermédiaire de nitrure et/ou carbure hypostœchiométrique contenant 0,2 à 0,3 atome d'oxygène par atome de métal.

14. Procédé selon la revendication 12 ou 13, caractérisé en ce que pour former un revêtement ou revêtement intermédiaire hypostœchiométrique disposé sous le revêtement de recouvrement, formé de plusieurs couches présentant des teneurs différentes en formateurs non métalliques de matière dure, au cours du dépôt de ce revêtement ou revêtement intermédiaire, on modifie la teneur de la phase gazeuse en gaz fournissant les formateurs non métalliques de matière dure qui sont l'azote et/ou le carbone, et éventuellement de l'oxygène.